# EUROPEAN PATENT SPECIFICATION

(11) **EP 0 599 039 B1**
(45) Date of publication and mention of the grant of the patent: **04.06.1997**
(21) Application number: 93116514.6
(22) Date of filing: 12.10.1993
(51) Int. Cl.: C23F 1/08

(54) **Etch control system**
Ätzregelssystem
Système de contrôle de décapage

(30) Priority: 09.11.1992 US 973679; 23.07.1993 US 95400
(43) Date of publication of application: 01.06.1994
(73) Proprietor: BMC INDUSTRIES, INC., Minneapolis, MN 55420 (US)
(72) Inventor: Thoms, Roland H., Cortland, N.Y. 13045 (US)
(74) Representative: Modiano, Guido, Dr.-Ing.

(56) References cited:
- EP-A- 0 037 551
- EP-A- 0 354 266
- DE-A- 2 001 790
- FR-A- 2 347 456
- US-A- 3 788 912
- US-A- 4 852 595
- US-A- 4 985 111
- DATABASE WPI Derwent Publications Ltd., London, GB; AN 84-148850 & JP-A-59 076 878 (HITACHI CHEMICAL KK)

## Description

### FIELD OF THE INVENTION

This invention relates generally to etching metal webs and, more particularly, to means and method for more quickly and automatically making on-the-go adjustments to the etchant rate on the metal web without having to shutdown the system to adjust and fine-tune the etching equipment and without having to change the fluid pressure or flow rate through the etching nozzles.

### CROSS REFERENCE TO RELATED APPLICATIONS

This application is a continuation-in part of my co-pending U.S. patent application SN. 07/973,679 titled Etchant Distribution Apparatus filed November 9, 1992.

### BACKGROUND OF THE INVENTION

In the etching of metal webs, and, in particular, in the etching of metal webs from opposite sides, it is difficult to uniformly control the distribution of etchant throughout the metal web. If holes are being etched in the metal web, the size and shape of the holes may vary substantially as a result of non-uniform etchant distribution.

One method used to more uniformly distribute the etchant is to place a first set of oscillatable etchant spray nozzles above the metal web and a second set of oscillatable etchant spray nozzles below the metal web, with both sets of oscillatable nozzles spraying etchant directly onto the metal web. The nozzles are then oscillated in accordance with a sinusoidal waveform generated by a rotating wheel. The result is an etching process which has better dimensional controls, since the oscillating nozzles more uniformly distribute the etchant on the metal web than non-oscillating nozzles.

However, even with oscillating the nozzles, the spray patterns may not be uniform, sometimes resulting in uneven etching. The problem with uneven etching is that once breakthrough occurs in a metal web, that is, a hole has been formed in the web, etching proceeds at a much more rapid rate, since fresh etchant is continuously applied to the sides of the hole. The result is that a first pre-breakthrough etching rate exists, and a second post-breakthrough etching rate exists after the opening or hole is formed. Consequently, if enlargement of all the holes in the metal are not begun simultaneously, the holes can become irregular and misshapen as a result of the different etching rates before and after breakthrough.

One of the goals of the oscillatable nozzles is to more uniformly distribute etchant to have the breakthrough occur at substantially the same time throughout the metal web. If the rate of etching proceeds at a constant rate throughout the metal web, one can accurately control the final dimensions of openings formed in the metal web. However, changing etching conditions or varying thickness of the metal web may require changing the etching rate by changing the delivery of the etchant to the metal web.

To change the spray pattern of the oscillating nozzles or to change the etching rates usually requires system shutdown so the operators can make manual adjustments to the nozzle stroke as well as other adjustments to the system. In some cases, the pressure to the nozzles or the flow rate to the nozzles is changed to control the etchant rate. Typical of such a system is the control system shown in U.S. patent 3,645,811, which shows a system that changes etchant valve settings in response to measurements of the size of openings in the aperture mask.

In general, the concept of etching equipment in which the size of the holes in the aperture mask is monitored and more or less etchant is applied to the mask is known in the art. Another such system is shown in U.S. patent 3,756,898 which relates to an etching system for enlarging holes without the aid of an etchant resist.

Typically, in these prior art systems, more or less etchant is sprayed through the individual nozzle by opening or closing the valves. In addition, the position of the nozzles above the mask can be adjusted to put more or less etchant in one particular area.

In still other types of etching systems, which use a protective etchant resist located over a traveling web material, the pressure of the etchant is typically increased or decreased to increase or decrease the etchant flow to change the etching rate of the material. Typically etchant spray nozzles, which are located above and below the material; are oscillated at a predetermined frequency. In order to control the size and shape of etched holes in the web material passing between the spray nozzles, one can increase or decrease the etchant rate on the web passing between the nozzles. For example, the amplitude of the nozzle oscillation may be changed or the speed of the oscillation may be changed or the angle of spray from the nozzle, may be changed. Depending on the material and other conditions, such adjustments will change the size of the final hole in the web material. These changes in etchant supply are necessary to compensate for changing etching conditions and variations in metal web thickness and shape. This problem is particularly acute when one roll of metal web is fastened to another since each roll of metal web has its own individual characteristics. That is, the thickness of some webs may vary or some webs instead of having a rectangular cross-sectional shape may have a convex shape, a concave shape or a general triangular cross-sectional shape. Consequently, the transition from one roll of web material to another during an inline etching process may cause variations in the size or shape of the etched openings in the web if the etching rate is not adjusted accordingly.

While the adjustments to the nozzle flow rate and etchant distribution can be accomplished to compensate for changes in web shape and size, one of the problems with these adjustments is that in systems where one is etching precision openings, such as those that have a minimum dimension less than the thickness of the metal. it takes time to make the necessary adjustments to the etching system after the measurements have been made. Typically, in an inline etching system, after the mask leaves the etching chamber, requires approximately 20 minutes until the holes in the mask have been measured and the information regarding the size of the holes is available to the operator. However. it may take up to 16 hours or more of manual adjustments to the etching stations and observations of the effect of the adjustments before one can determine that the etching system has been properly adjusted for the web material in the etching system.

It is therefore an object of the present invention to provide an etching apparatus and an etching process wherein manual adjustments of oscillation amplitude, frequency and nozzle angle can be virtually eliminated without having to alter the pressure or flow rate of the etchant through the nozzles. This object and more objects which will appear more clearly hereinafter are achieved by an etching apparatus according to claim 1 and by an etching method according to claim 11. The dependent claims concern preferred embodiments of the invention. The use of members to automatically change the waveform of the oscillating nozzle spraying etchant onto the mask provides an on-the go etchant spray distribution system in which one can quickly compensate for changing etching conditions by changing the waveform of the means for oscillating the nozzles to produce the desired etching correction. Such changes normally would require changing the etchant distribution pattern on the mask by change the nozzle pressures, spacing, or flow rates or the speed of the web in the etching chambers. A further benefit is that unwanted etching changes resulting from coaction between the etchant spray and the metal are virtually eliminated because the pressure and flow rates in the nozzle can remain the same before and after the change in the waveform.

### DESCRIPTION OF THE PRIOR ART

U. S. patent 3,645,811 shows an etching system for controlling the size of apertures by spraying more or less etchant on a mask in response to the measurement of the hole size.

U.S. patent 3,401,068 shows an etching control system for controlling the etching by controlling the conveyor speed of the material carried through the etching chambers.

U.S. patent 3,419,446 shows an alternate embodiment of a variable speed drive for controlling the etching rate by controlling the conveyor speed of the material carried through the etching chambers.

U.S. patent 3,669,771 shows the use of an air source and photocell to measure the hole size in an aperture mask.

U.S. patent 3,788,912 shows a system for enlarging openings in aperture masks in which the etching rate is controlled by vertically positioning of the nozzles above the mask.

U.S. patent 3,808,067 shows a method of controlling an etching process wherein the etchant flow rate or the conveyor speed is adjusted according to the difference between measurements taken from the etched article and a standard measure.

U.S. patent 4,124,437 shows an etching system with upper and lower oscillating nozzles.

U.S. patent 4,126,510 shows an etching system in which the thickness of the metal strip is monitored and etching is adjusted by changing the pressure or turbulence of the etching system.

U.S. patent 4,985,111 shows a cylinder for controlling a gate valve to alterantly open and close the supply lines to the etching nozzles to delver the fluid sequentially to prevent etchant puddling on the article.

U.S. patent 5,002,627 shows a spray-etching apparatus for individually controlling etching jets wherein the spray pressure of the jets is altered to change the etching rate.

U.S. patent 5,200,023 shows a etching system in which an infrared television camera monitors the etching of a substrate in an etching chamber, and feedback control is achieved by adjusting parameters such as gas pressure, flow pattern, magnetic field or coolant flow to the electrode.

### BRIEF SUMMARY OF THE INVENTION

An etching system for etching openings in a metal web including an etching station for etching a metal web from opposite sides with the etching system including a first bank of oscillatable nozzles located in a first chamber in the etching station, with the first bank of oscillatable nozzles having predetermined spacings from one another, and operable for directing etchant at a first side of a metal web. The system includes a second bank of oscillatable nozzles located in a second chamber in the etching station, with the second bank of oscillatable nozzles having a predetermined spacing substantially identical to the first bank of oscillatable nozzles with the second set of oscillatable nozzles laterally offset from the first set of nozzles, so as not to spray on directly opposite regions located on the metal web. In addition, the oscillation axis of the nozzles is off normal so that etchant is sprayed in general elliptical patterns on the metal web with the control of the etchant rate accomplished by means such as a waveform generator that changes the waveform of the oscillating nozzle to alter the pattern of etchant sprayed onto a region of the metal web and thereby compensate for on-to-go changes in etching conditions or in the thickness of the metal web without having to change the etchant pressure or the etchant flow rate to the nozzles.

### BRIEF DESCRIPTION OF THE DRAWINGS

Figure 1 is a partial schematic view of upper and lower etching chambers located proximate a moving web;
Figure 2 is a view taken along lines 2-2 of Figure 1;
Figure 3 is a view taken along lines 3-3 of Figure 1;
Figure 4 shows a partial sectional view of an etching station upper spray nozzles and lower spray nozzles with the lower spray nozzles located in phantom;
Figure 5 shows a partial sectional view of the oscillating system and a partial spray pattern as a result of the oscillation by a mechanical drive;
Figure 6 is a graph representing the depth of etch as a function of the mask position for various types of etchant distribution systems.
Figure 7 shows a partial sectional view of the oscillating system of Figure 5 powered by a single pressure-activateable cylinder;
Figure 8 shows a partial sectional view of the oscillating system of Figure 5 powered by two pressure activateable cylinders;
Figure 9 shows block diagram of a system for measuring, comparing and effecting etching rate changes by changing the waveform of the oscillating nozzle;
Figure 10 shows the sinusoidal waveform of the oscillating system powered by a mechanical drive;
Figure 11 shows an alternate waveform of the oscillating system powered by the pressure-controllable two-way hydraulic cylinders of Figure 7;
Figure 12 shows a further alternate waveform of the oscillating system powered by the pressure-controllable, two-way hydraulic cylinders of Figure 7; and
Figure 13 shows a further alternate complex waveform of the oscillating system powered by the pressure-controllable, two-way hydraulic cylinders of Figure 8.

### DESCRIPTION OF THE PREFERRED EMBODIMENT

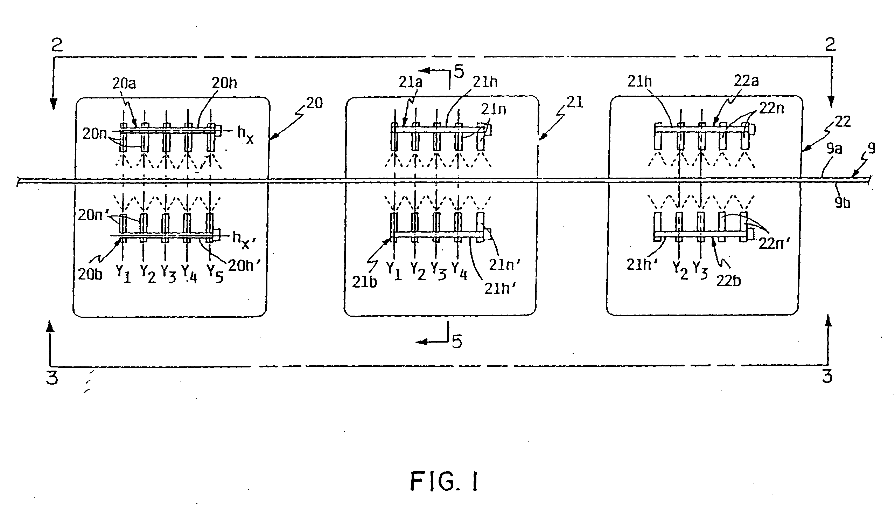

Figure 1 shows a partial schematic side view of etching stations 20, 21 and 22, with a metal web 9 extending horizontally therethrough. As web 9 passes through the etching stations, each of the nozzles sprays etchant onto the metal web. Etching station 20 includes an upper etching chamber 20a and a lower etching chamber 20b. Etching chamber 20a includes upper header 20h with a plurality of nozzles 20n which are oscillatable about header axis hₓ. Similarly, etching chamber 20b located on the underside of web 9 includes header 20h' which have nozzles 20n' which are oscillatable about header axis h'ₓ through header 20h'. To illustrate the vertical spacing and alignment of the nozzles, Figure 1 shows planes y₁, y₂, y₃, y₄ and y₅ drawn through lower nozzles 20n' and upper nozzles 20n which are located in etching chamber 20. Similarly, etching chambers 21 and 22 have the same vertical spacing and vertical alignment of etching nozzles located therein.

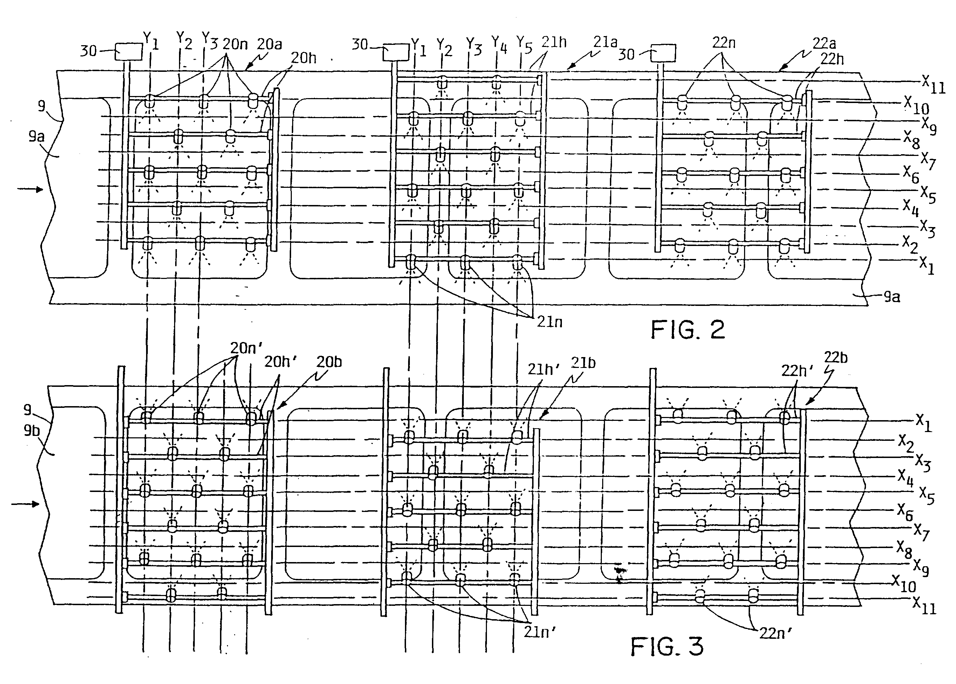

Figures 2 and 3 illustrate in partial schematic the location and arrangement of the oscillating nozzles in each etching chamber. The bank of upper nozzle and the bank of lower nozzles are laterally offset from one another with the bank of nozzles in adjacent chambers also offset from adjacent banks of nozzles. Reference numeral 20n identifies the first set of upper oscillatable nozzles in chamber 20. The oscillatable nozzles 20n are located on five headers 20h which are located in a spaced and parallel relationship to one another. Located on each of headers 20h are oscillatable nozzles 20n which direct etchant onto the top of web 9. A driving mechanism 30 oscillates headers 20h and nozzles 20n to spray etchant laterally across the top surface 9a of web 9.

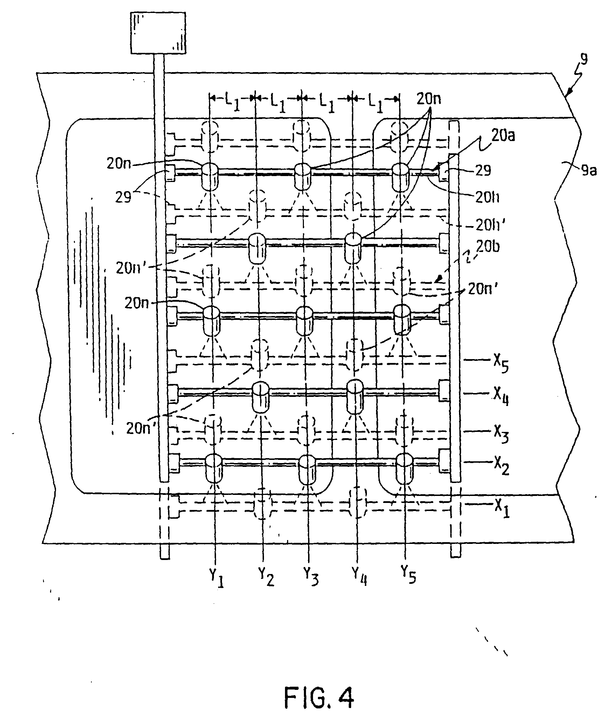

Etching chamber 21a includes a second set of identical oscillatable upper nozzles 21n. In addition, etching chamber 21 includes an extra row of nozzles. Similarly, etching chamber 22a includes a third set of identical, oscillatable upper nozzles 22n. Oscillatable nozzles 20n and 22n are identical in their position and oscillation with respect to web 9, while oscillatable nozzles 21n are offset from the nozzles 20n and 22n. To illustrate the offset relationship of the upper nozzles, a series of parallelly spaced reference planes x₁ through x₁₁ extend vertically through stations 20, 21 and 22. To illustrate the offset relationship of the upper nozzles with respect to the lower nozzles, reference should be made to Figure 4 which shows the upper nozzles 20n in solid and the lower nozzles 20n' in phantom.

Figure 4 illustrates the lateral offset of the upper and lower banks of the oscillating nozzles which occurs in a single etching station. The bank of upper nozzles 20n located above web 9 is shown in solid lines, and a bank of lower oscillating nozzles 20n' is shown in dashed lines. Attention is called to the fact that each of the nozzles is located in equally spaced planes y₁ through y₅, which are perpendicular to web 9 and extend vertically downward from the top oscillating nozzles 20n through the lower oscillating nozzles 20n'.

Figure 4 illustrates the lateral offset of upper nozzles 20n from the lower nozzles 20n'. The upper nozzles 20n are located in even planes x₂, x₄, etc., while the lower nozzles 20n' are located in odd planes, x₁, x₃, x₅, etc. From the drawing, it can be seen that lower nozzles 20n' are spaced midway between the upper nozzles 20n and staggered thereout, so they do direct etchant on the opposed portions on the top and bottom of web 9. Thus, Figure 4 illustrates that the grid pattern formed by the nozzles in the upper chamber and lower chamber of the same etching station are substantially identical except they are offset from one another so they do not spray etchant onto opposed regions on the opposite sides of web 9.

To illustrate the offsetting of nozzles in each etching station with respect to adjacent etching stations, reference should be made to Figures 2 and 3. Figures 2 and 3 are laid out so that the upper and lower views of etching chambers 20, 21 and 22 are in alignment with one another. To illustrate the offset of nozzles 20n, 21n and 22n in upper etching chambers 20, 21 and 22, reference planes have been drawn perpendicular to web 9 and are identified by x₁ through x₁₁. The position of planes x₁ through x₁₁ is also shown in Figure 3 to show the position of the lower bank of nozzles 20n', 21n' and 22n' with respect to the same reference planes.

Figure 2 shows that the upper nozzles 20n and 22n are located in even reference planes x₂, X₄, x₆, x₈ and x₁₀, while the central station oscillating nozzles 21 oscillate about the odd planes which extend along planes x₁, x₃, x₅, x₇, x₉ and x₁₁. Thus, it is apparent that the nozzles in the top chambers of adjacent etching stations are offset from one another. Similarly, the nozzles in each of the bottom etching stations are also offset from one another. That is, the lower bank of nozzles 21n' oscillate about even planes x₂, x₄, x₆, x₈ and x₁₀, while nozzles 20n' in station 20b and nozzles 22n' in station 22b oscillate about the odd planes x₁, x₃, x₅, x₇, x₉ and x₁₁. Thus, is can be seen that not only the top and bottom banks of nozzles are offset from one another, but both the top and bottom banks of nozzles in adjacent etching stations are offset from one another, thus providing a double offset so that no one region of the web receives a same or similar spray etching from an adjacent etching station.

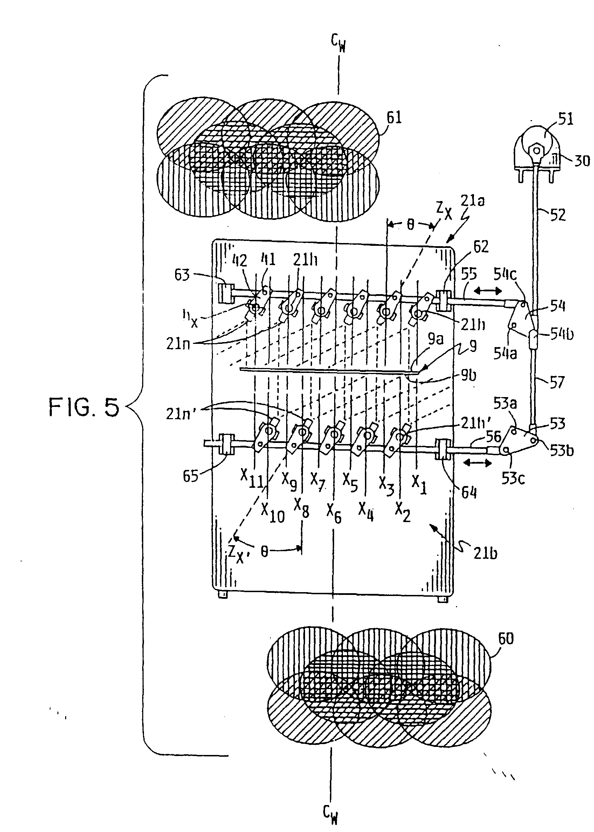

Figure 5 shows a partial schematic taken along lines 5-5 of Figure 1. Figure 5 illustrates a mechanism for oscillating the upper and lower banks of nozzles as well as a partial nozzle spray pattern 61 on the upper side 9a of web 9 and a partial nozzle spray pattern 60 on the lower side 9b of web 9.

Figure 5 shows that the axis of oscillations of the nozzles are offset a predetermined angle from a vertical axis to provide an elliptical spray pattern on both the top and bottom of the mask.

To illustrate the relationship of the oscillating nozzles of the upper and lower chamber in a single etching station, reference should be made to Figure 5. Since each of the oscillating nozzles is identical in the upper and lower chamber, only one nozzles will be described with respect to its oscillation about an axis hₓ extending through its header.

Reference numeral 21n identifies an oscillating nozzle having a pivot pin 41 and an arm 42. Oscillating nozzle 21n is located on header 21h and oscillates about header axis hₓ. When the oscillating nozzles 21n are operating, a motor 30 drives a crank 51 which connects to arms 52 and 57. Arm 52 connects to upper pivotal plate 54 and lower pivotal plate 53. Upper pivotal plate 54 pivots about pivot pin 54a, and, similarly, lower pivot plate 53 pivots about pivot pin 53a. The back-and-forth movement of arm 52 moves arm 57 which is pivotally connected to plate 54 by pivot pin 54b and to plate 53 by pivot pin 53b. Since pivot pins 53a and 54a are fixed, pivot plate 54 forces member 55 to oscillate back and forth in a direction indicated by the arrows. Similarly, pivot plate 53 forces member 56 to oscillate back and forth in the direction indicated by arrows. As a result of the driving action of motor 30, the upper nozzles 21n which are connected to member 55 oscillate about a non-vertical axis zₓ. Similarly, the lower nozzles oscillate about a low non-vertical axis z'ₓ., which is parallel to axis z_{x.} As the upper and lower nozzles oscillate, they spray etchant onto web 9. The upper overlapping spray pattern of three adjacent rows of nozzles is indicated by reference numeral 61, and comprises a plurality of elliptically shaped regions. Similarly, the lower overlapping spray pattern of three adjacent rows of nozzles is indicated by reference numeral 60 on the underside of web 9 and also comprises a plurality of elliptical shaped regions which, as shown in the drawing, are biased to the right, while the spray pattern on top is biased to the left. While the spray pattern in adjacent stations is substantially identical, the spray pattern in adjacent stations is offset since the nozzles in adjacent stations are offset from one another.

The elliptically shaped regions 60 and 61 result from the axis zₓ of each of the nozzles being offset at an angle of approximately 33 degrees from a line extending perpendicularly to web surface 9. Reference letter *theta* on the drawing indicates the offset angle. In the preferred embodiment, the nozzles are spaced about five to 12 inches from the metal web and oscillate within the frequency range of 30 to 60 cycles per minute and have a maximum oscillation angle about axis z_{x'} or axis zₓ which ranges from approximately 10 degrees to 30 degrees on each side of the axis z_{x'} or axis z_{x.}

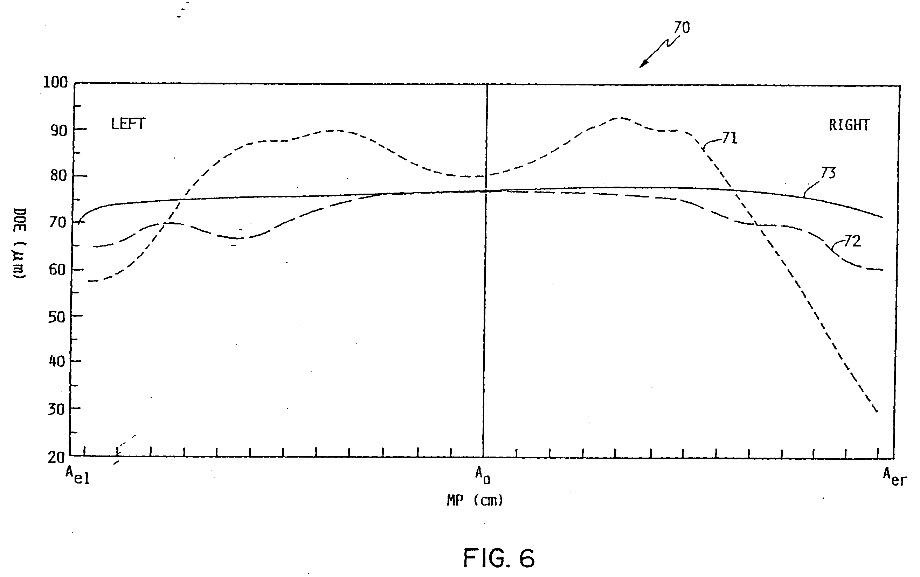

To illustrate the depth of etch on a metal web under different oscillating spray conditions, reference should be made to Figure 6. The vertical axis identifies the depth of etch, while the horizontal axis identifies the lateral position across a shadow mask. The reference Aₒ indicates the center of the mask Aₑₗ indicates the left edge of the mask and Aₑᵣ indicates the right edge of the mask.

Graph 71 identifies the variation of depth of etch when stationary nozzles are used. Note that the depth of etch varies considerably from one side of the mask to the other side. Under these conditions, breakthrough would occur throughout the mask at different times.

Graph 72 identifies the variation of depth of etch from one side of the mask to the other side of the mask in prior-art systems. Note that the depth of etch, although varying considerably from one side to the other, is more uniform than if stationary nozzles were used.

Graph 73 identifies the variation of depth of etch from one side of the mask to the other side with the etchant distribution system using oscillating nozzle system of Figure 5. Note that the depth of etch remains substantially constant from one side to the other side of the mask. The result is that, when etching a metal web from opposite sides, the goal of obtaining a breakthrough at virtually identical times will be substantially achieved. With breakthrough occurring in the mask at virtually the same time, one is assured that, although different etching rates exist prior to and after breakthrough, the etching at varying regions across the mask will be substantially the same so that the final dimensions of the aperture can be more accurately controlled.

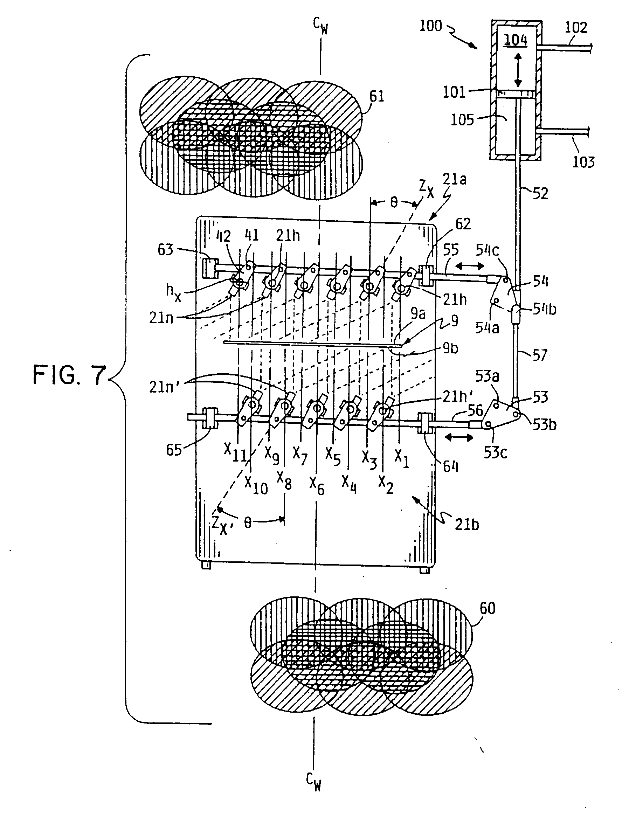

Figure 5 shows the nozzles being oscillated by a mechanical oscillator driven by a rotating crank Figure 7 shows the identical etching system being driven by a hydraulic cylinder 100. The hydraulic cylinder has a slidable piston 101 located therein. Located on one end of cylinder 100 is a first chamber 104 connected to a hydraulic line 102 for directing hydraulic fluid into or out of chamber 104. Similarly, located on the opposite end of cylinder 100 is a second chamber 105 connected to a hydraulic line 103 for directing hydraulic fluid into or out of chamber 105.

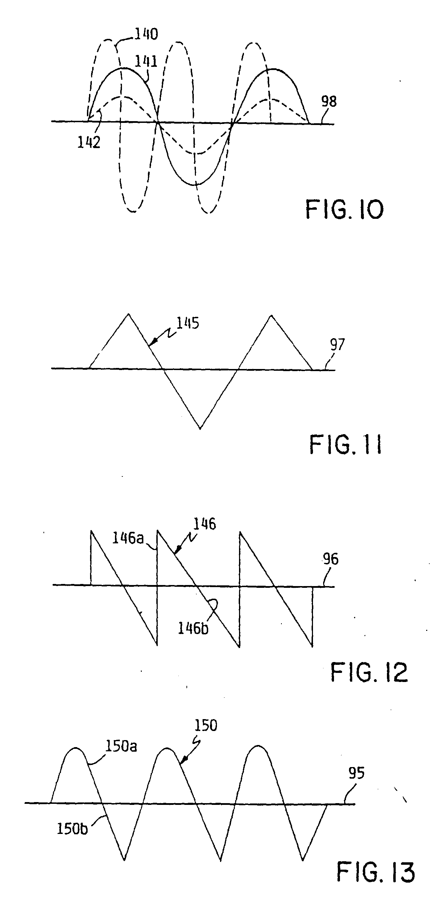

Referring to Figure 10, reference numeral 98 identifies a reference axis and reference numerals 140, 141 and 142 identify the sinusoidal motion of the tips of the nozzles as they are driven by the mechanical oscillator shown in Figure 6. That is, a rotating crank drives the nozzles in a sinusoidal waveform. As part of the adjustment for the etching stations, the nozzle frequency can be increased as indicated by curve 140 or the frequency can be kept the same, as indicated by curve 141 and cure 142, while the amplitude is decreased. However, in each case, the change to the mechanically rotating crank stroke provides a sinusoidal waveform to the tips of the nozzle. In some cases, the amplitude of the sinusoidal wave may be greater or lesser, and, in other cases, the frequency may be increased or decreased, but in all cases, the crank rotating at a constant speed produces a sinusoidal waveform. It should be pointed out that reference to the waveform of the nozzles is the time path followed by the nozzles as they oscillates from side to side within the etching chamber. It is also the time movement of the piston in the hydraulic cylinder in response to control signals from a wave generator.

Referring to Figure 11, reference numeral 97 identifies a reference axis and reference numeral 145 shows one of a number of possible waveforms that hydraulic cylinder 100 may follow. That is, 145 denotes a saw-tooth waveform as opposed to the sinusoidal waveform shown in Figure 10.

Similarly, in Figure 12, reference numeral 96 identifies a reference axis and reference number 146 identifies another non-sinusoidal waveform with an abrupt return 146a followed by a gradually sweeping motion as indicated by 146b.

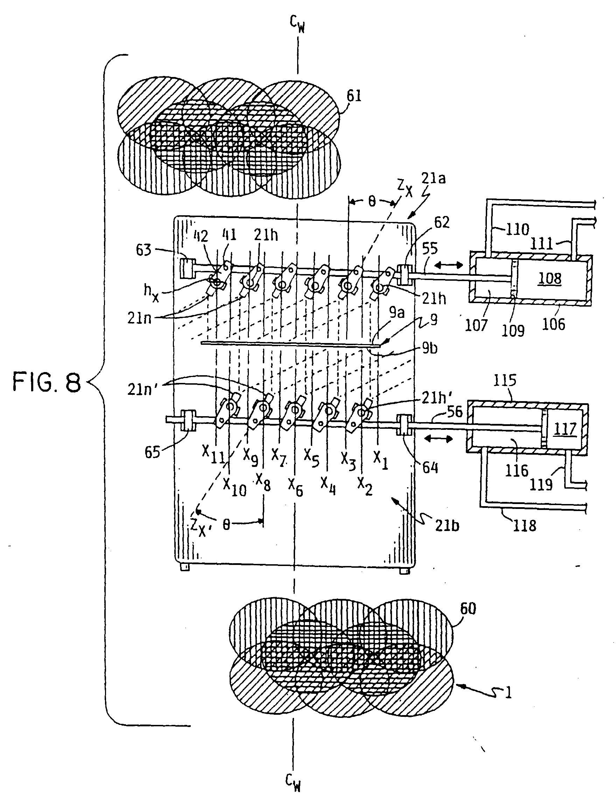

Figure 13 further illustrates a complex waveform obtainable with the hydraulic cylinder system shown in Figure 7 or Figure 8. That is, the shape of the first portion of the waveform 150a located above the axis 95 may be sinusoidal and the lower portion of the waveform 150b may be saw-tooth. By measuring the effects of waveform on etchant rate, one can obtain reference information correlating the etchant rate to a particular waveform of the etchant nozzles. Thus, the path of the oscillation of the nozzles tips and, consequently, the etchant projectory in which the etchant is sprayed is not limited in accordance with the sinusoidal waveform. Furthermore, by use of two independent hydraulic cylinders as shown in Figure 8, the path of oscillation of the nozzles in the upper chamber can be oscillated independent of the path of oscillation of the nozzles in the lower chamber. While hydraulic cylinders are shown as the means to change the waveform of the nozzles, other drive means that can change the waveform while on-the-go could also be used.

Figures 11-13 illustrate the difference between changing the waveform and Figure 100 illustrates what is meant by changing the wave shape such as altering the frequency or amplitude of the wave.

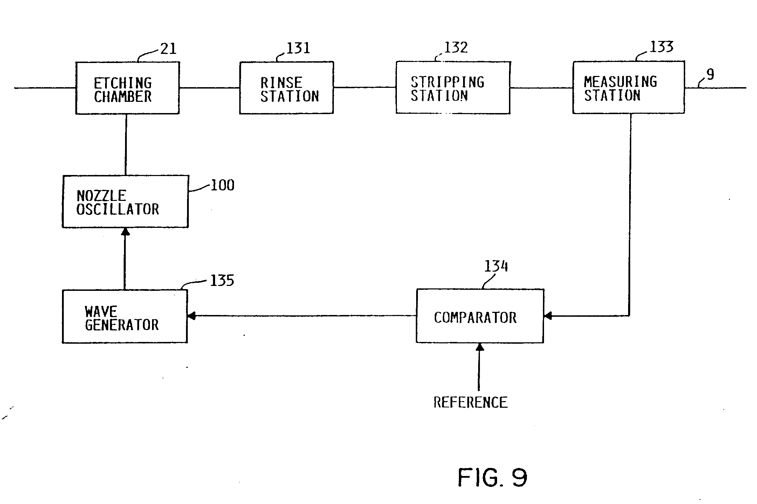

Figure 9 shows a block diagram of portion of an aperture mask etching system for controlling the etching rate without having to change the pressure of flow rate of the etchant by feeding back information from etched masks to masks where etching has not yet been completed. Reference numeral 9 identifies the moving web, reference numeral 21 identifies etching chambers; reference numeral 131 identifies an inline etchant rinse station and reference numeral 132 identifies an inline etchant-resist stripping station.

Located after the stripping station 132 is an inline measuring station 133 which typically includes a densitometer or some other type of measuring device to measure the size or shape of the openings in the aperture mask. One such device is more fully shown and described in U.S. patent 3,645,811. The measurements of the hole size or shape are converted to an electrical signal which is sent to a signal comparator 134 where it is compared to a reference signal. Based on the differences between the reference signal and the signal from measuring station, a corrective signal, if any is necessary, is sent to the wave generator 135, which generates the appropriate waveform to drive the nozzle oscillator 100-101 in accordance with the required correction. That is, the spray pattern on the metal web is changed by solely changing the waveform of the nozzles. Consequently, more or less etchant can be delivered to different portions of the mask and the corrections to the etching chamber can be done on-the-go and automatically without the necessity of resetting pressures in the system or mechanically adjusting the amplitude of the oscillation.

While the system is described in relation to staggered and offset nozzles, the control system is also suitable for other oscillating nozzle systems. While changes in etching pasterns can be obtained by changing the angle of oscillation of the nozzles as well as the axis of oscillation, the use of changing waveform allows changes to the etching rate without having to manually adjust the system. Although the present invention is described with respect to staggered and offset oscillating nozzles, the system can be used with other arrangements of oscillating nozzles.

Where technical features mentioned in any claim are followed by reference signs, those reference signs have been included for the sole purpose of increasing the intelligibility of the claims and accordingly, such reference signs do not have any limiting effect on the scope of each element identified by way of example by such reference signs.

## Claims

1. An etching apparatus for etching a metal web (9) by spraying etchant through oscillating nozzles (20n, 20n') comprising:
one or more etching stations (20, 21, 22) located adjacent to one another along a web (9) to be etched, each etching station (20, 21, 22) comprising at least a first and optionally a second etching chamber (20a, 20b), said first etching chamber (20a) being located above and said second etching chamber (20b) being located under said web, each etching chamber comprising a bank (20h, 20h') bearing a set of oscillatable nozzles (20n, 20n') for directing etchant to said web (9), said nozzles (20n, 20n') having predetermined spaces from one another,
and a means (133) for measuring the size or shape of the holes in said web (9), said means (133) further generating a signal being compared with a reference signal thereby providing a corrective signal which is delivered to a means (100) for controlling the etching conditions,
characterized in that
each set of oscillatable nozzles (21n) in a first etching chamber (21a) of a first etching station (21) is laterally offset from the sets of oscillatable nozzles (20n, 22n) in adjacent etching chambers (20, 22) of adjacent etching stations (20a, 22a) on the same side of said web (9a) as well as from the set of oscillatable nozzles (21n') in the optional second etching chamber (21b) of said first etching station (21) on the opposite side of said web (9b), thus providing a double offset so that no one region of said web (9) receives a same or similar spray etching from adjacent etching stations (20, 21, 22),
the etching conditions being controlled by altering solely the waveform of the nozzle oscillation.

2. The etching apparatus according to claim 1, characterized in that each of said etching stations (20, 21, 22) comprises just one etching chamber (20a, 21a, 22a), all etching chambers being located on the same side of the web.

3. The etching apparatus according to claim 1 or 2, characterized in that said oscillatable nozzles (20n, 20n') are oscillated
in accordance with a given waveform to provide a given pattern of etchant spray on the web (9)
and in accordance with a different waveform in response to said corrective signal to compensate, if necessary, for changing etching conditions or changes in the thickness of said web (9) by providing a different pattern.

4. An etching apparatus according to one or more of the preceding claims, characterized in that said changes in the waveform are made on-the-go.

5. An etching apparatus according to one or more of claims 1, 3 or 4, characterized in that said banks (20h, 20h') of oscillatable nozzles (20n, 20n') of both of said etching chambers (20a, 20b) of a given etching station (20) are oscillated in accordance with said given waveform.

6. An etching apparatus according to claim 5, characterized in that said means (100) for controlling the etching conditions comprises a pressure-activable hydraulic cylinder.

7. An etching apparatus according to one or more of the preceding claims, characterized in that said oscillatable nozzles (20n, 20n') of each of said etching stations (20, 21, 22) are oscillated in accordance with a given waveform,
and in that the given waveforms governing the oscillation of said oscillatable nozzles (20, 20n') in adjacent etching stations (20, 21, 22) are different from each other.

8. An etching apparatus in accordance with one or more of claims 1, 3-4 and 7, characterized in that said first bank of oscillatable nozzles (20h) of said first etching chamber (20a) in a given etching station (20) is oscillated in accordance with a first given waveform
and in that said second bank (20h') of oscillatable nozzles of said second etching chamber (20b) in said given etching station (20) is oscillated in accordance with a second given waveform.

9. An etching apparatus in accordance with claim 8, characterized in that said means (100) for controlling the etching conditions includes at least two pressure-activable hydraulic cylinders for controlling the waveform of at least some nozzles (21n) independently of other nozzles (21n').

10. An etching apparatus in accordance with one or more of the preceding claims characterized in that said banks (20h, 20h') of nozzles have an axis of oscillation of about 33 degrees from a normal to the surface of said metal web (9).

11. A method of spray etching of a metal web (9) by uniformly distributing etchant onto said web (9) comprising:
establishing one or more first grid patterns of oscillatable nozzles (20n, 21n, 22n) for etching said web (9) from one side of said web (9a),
optionally establishing one or more second grid patterns of oscillatable nozzles (20n', 21n', 22n') for etchinq said web (9) from the opposite side of said web (9b),
each of said grid patterns being laterally offset from adjacent grid patterns on the same side of the web (9a) as well as from the optional opposite grid pattern on the opposite side of said web (9b), thus providing a double offset,
oscillating all the nozzles (20n, 20n') in accordance with a given waveform while spraying etchant from the oscillatable nozzles (20n, 20n') onto the metal web (9),
measuring the size or shape of the holes in said web (9), thereby generating a signal being compared with a reference signal, thereby providing a corrective signal for controlling the etching conditions by altering solely the waveform of the nozzle oscillation.

12. The method in accordance with claim 11, characterized in that said grid patterns of oscillatable nozzles (20n) for etching the metal web are provided solely on one side of said web (9a).

13. The method in accordance with claim 11 or 12, characterized in that changes in the waveform are made on-the-go.

14. The method in accordance with one or more of claims 11-13 characterized in that it includes the step of oscillating each of the nozzles (20n, 20n') over an angle of approximately 60 degrees, with the axis of the center of oscillation located at an angle of approximately 33 degrees to an axis perpendicular to the surface of said web (9).

15. The method in accordance with one or more of claims 11-14, characterized in that the given waveforms governing the oscillation of adjacent grid patterns on the same side of the metal web (9a) are different from each other.

16. The method in accordance with one or more of claims 11 and 13-15, characterized in that the given waveforms governing the oscillation of opposite grid patterns on opposite sides of said web (9a, 9b) are different from each other.

## Patentansprüche

1. Ätzvorrichtung zum Ätzen eines Metallgeflechts (9) durch Sprühen von Ätzmittel durch oszillierende Düsen (20n, 20n') mit:
einer oder mehreren Ätzstationen (20, 21, 22), die benachbart zueinander entlang des zu ätzenden Geflechts (9) angeordnet sind, wobei jede Ätzstation (20,21,22) mindestens eine erste und optional eine zweite Ätzkammer (20a, 20b) aufweist, wobei die erste Ätzkammer (20a) über und die zweite Ätzkammer (20b) unter dem Geflecht angeordnet ist und jede Ätzkammer eine Einheit (20h, 20h') aufweist, die einen Satz von oszillierbaren Düsen trägt, mit denen Ätzmittel auf das Geflecht (9) geführt wird, und die Düsen (20n, 20n') vorbestimmte Abstände voneinander haben und Einrichtungen (133) zum Messen der Größe und Form der Löcher in dem Geflecht (9), wobei mit den Einrichtungen (133) außerdem ein Signal erzeugt wird, das mit einem Referenzsignal verglichen wird, wodurch ein Korrektursignal ermittelt wird, das einer Einrichtung (100) zur Steuerung der Ätzbedingungen zugeführt wird, dadurch gekennzeichnet, daß
jeder Satz von oszillierbaren Düsen (21n) in einer ersten Ätzkammer (21a) einer ersten Ätzstation (21) seitlich gegenüber den Sätzen von oszillierbaren Düsen (20n, 22n) in benachbarten Ätzkammern (20, 22) von benachbarten Ätzstationen (20a, 22a) auf der gleichen Seite des Geflechts (9a), ebenso wie gegenüber dem Satz von oszillierbaren Düsen (21n') in der optionalen zweiten Ätzkammer (21b) der ersten Ätzstation (21) auf der gegenüberliegenden Seite des Geflechts (9b) versetzt ist, um dadurch einen doppelten Versatz zu erzielen, so daß kein Bereich des Geflechts (9) eine gleiche oder ähnliche Sprühätzung von benachbarten Ätzstationen (20, 21, 22) erhält, und daß
die Ätzbedingungen durch alleiniges ändern der Wellenform der Düsenoszillation gesteuert werden.

2. Ätzvorrichtung nach Anspruch 1,
dadurch gekennzeichnet, daß jede Ätzstation (20, 21, 22) genau eine Ätzkammer (20a, 21a, 22a) aufweist und alle Ätzkammern auf der gleichen Seite des Geflechts angeordnet sind.

3. Ätzvorrichtung nach Anspruch 1 oder 2,
dadurch gekennzeichnet, daß die oszillierbaren Düsen (20n, 20n') zur Erzeugung eines gegebenen Musters des Ätzrnittel-Sprühnebels auf dem Geflecht (9) entsprechend einer gegebenen Wellenform oszillieren und entsprechend einer anderen Wellenform als Antwort auf das Korrektursignal zur gegebenenfalls erforderlichen Kompensation von Änderungen der Ätzbedingungen oder Änderungen der Dicke des Geflechts (9) durch Erzeugung eines anderen Musters oszillieren.

4. Ätzvorrichtung nach einem oder mehreren der vorhergehenden Ansprüche,
dadurch gekennzeichnet, daß die Änderungen der Wellenform während des Betriebes ("on-the-go") erfolgen.

5. Ätzvorrichtung nach einem oder mehreren der Ansprüche 1, 3 oder 4,
dadurch gekennzeichnet, daß die Einheiten (20h, 20h') von oszillierbaren Düsen (20n, 20n') beider Ätzkammern (20a, 20b) einer gegebenen Ätzstation (20) entsprechend der gegebenen Wellenform oszillieren.

6. Ätzvorrichtung nach Anspruch 5,
dadurch gekennzeichnet, daß die Einrichtung (100) zur Steuerung der Ätzbedingungen einen durch Druck aktivierbaren hydraulischen Zylinder aufweist.

7. Ätzvorrichtung nach einem oder mehreren der vorhergehenden Ansprüche,
dadurch gekennzeichnet, daß die oszillierbaren Düsen (20n, 20n') der Ätzstationen (20, 21, 22) entsprechend einer gegebenen Wellenform oszillieren und daß sich die gegebenen Wellenformen, die die Oszillation der oszillierbaren Düsen (20n, 20n') regeln, in benachbarten Ätzstationen (20, 21, 22) voneinander unterscheiden.

8. Ätzvorrichtung nach einem oder mehreren der Ansprüche 1, 3 bis 4 und 7,
dadurch gekennzeichnet, daß die erste Einheit (20h) von oszillierbaren Düsen der ersten Ätzkammer (20a) in einer gegebenen Ätzstation (20) entsprechend einer ersten gegebenen Wellenform oszilliert, und daß die zweite Einheit (20h') von oszillierbaren Düsen der zweiten Ätzkammer (20b) in der gegebenen Ätzstation (20) entsprechend einer zweiten gegebenen Wellenform oszilliert.

9. Ätzvorrichtung nach Anspruch 8,
dadurch gekennzeichnet, daß die Einrichtung (100) zur Steuerung der Ätzbedingungen mindestens zwei durch Druck aktivierbare hydraulische Zylinder zur Steuerung der Wellenform der Oszillation von mindestens einigen der Düsen (21n) unabhängig von anderen Düsen (21n') aufweist.

10. Ätzvorrichtung nach einem oder mehreren der vorhergehenden Ansprüche,
dadurch gekennzeichnet, daß die Einheiten (20h, 20h') von Düsen eine Oszillationsachse mit einem Winkel von etwa 33 Grad zur Senkrechten auf der Oberfläche des Metallgeflechts (9) aufweisen.

11. Verfahren zum Sprühätzen eines Metallgeflechts (9) durch gleichmäßige Verteilung von Ätzmittel auf dem Geflecht (9), mit folgenden Schritten:
Zusammenstellen von einem oder mehreren ersten Gittermustern von oszillierbaren Düsen (20n, 21n, 22n) zum Ätzen des Geflechts (9) von einer Seite des Geflechts (9a),
optionales Zusammenstellen von einem oder mehreren zweiten Gittermustern von oszillierbaren Düsen (20n', 21n', 22n') zum Ätzen des Geflechts (9) von der gegenüberliegenden Seite des Geflechts (9b), wobei
jedes Gittermuster gegenüber benachbarten Gittermustern auf der gleichen Seite des Geflechts (9a), ebenso wie gegenüber dem optionalen gegenüberliegenden Gittermuster auf der gegenüberliegenden Seite des Geflechts (9b), seitlich versetzt ist, so daß ein doppelter Versatz entsteht,
Oszillieren aller Düsen (20n, 20n') entsprechend einer gegebenen Wellenform, während Ätzmittel aus den oszillierbaren Düsen (20n, 20n') auf das Metallgeflecht (9) gesprüht wird,
Messen von Größe oder Form der Löcher in dem Geflecht (9), wodurch ein Signal erzeugt wird, das mit einem Referenzsignal verglichen wird, so daß ein Korrektursignal zur Steuerung der Ätzbedingungen durch alleinige Änderung der Wellenform der Düsenoszillation erzeugt wird.

12. Verfahren nach Anspruch 11,
dadurch gekennzeichnet, daß die Gittermuster der oszillierbaren Düsen (20n) zum Ätzen des Metallgeflechts nur auf einer Seite des Geflechts (9a) vorgesehen sind.

13. Verfahren nach Anspruch 11 oder 12,
dadurch gekennzeichnet, daß Änderungen der Wellenform während des Betriebes ("on-the-go") durchgeführt werden.

14. Verfahren nach einem oder mehreren der Ansprüche 11 bis 13,
dadurch gekennzeichnet, daß es den Schritt des Oszillierens aller Düsen (20n, 20n') über einen Winkel von näherungsweise 60 Grad umfaßt, wobei die Achse des Zentrums der Oszillation mit einem Winkel von näherungsweise 33 Grad zu einer Achse senkrecht zu der Oberfläche des Geflechts (9) angeordnet ist.

15. Verfahren nach einem oder mehreren der Ansprüche 11 bis 14,
dadurch gekennzeichnet, daß sich die gegebenen Wellenformen, die die Oszillation von benachbarten Gittermustern auf der gleichen Seite des Metallgeflechts (9a) regeln, voneinander unterscheiden.

16. Verfahren nach einem oder mehreren der Ansprüche 11 und 13 bis 15,
dadurch gekennzeichnet, daß sich die gegebenen Wellenformen, die die Oszillation von gegenüberliegenden Gittermustern auf gegenüberliegenden Seiten des Geflechts (9a, 9b) regeln, voneinander unterscheiden.

## Revendications

1. Appareil de décapage destiné à décaper une bande métallique (9) en pulvérisant un réactif de décapage à travers des buses oscillantes (20n, 20n') comprenant :
un ou plusieurs postes de décapage (20, 21, 22) situés adjacents les uns aux autres le long d'une bande (9) à décaper, chaque poste de décapage (20, 21, 22) comprenant au moins une première et éventuellement une deuxième chambre de décapage (20a, 20b), ladite première chambre de décapage (20a) étant située au-dessus et ladite deuxième chambre de décapage (20b) étant située au-dessous de ladite bande, chaque chambre de décapage comprenant un banc (20h, 20h') portant un ensemble de buses oscillantes (20n, 20n'), destinées à diriger le réactif de décapage vers ladite bande (9), lesdites buses (20n, 20n') ayant des espaces prédéterminés les unes par rapport aux autres,
et des moyens (133) pour mesurer la taille ou la forme des trous dans ladite bande (9), lesdits moyens (133) générant en outre un signal comparé à un signal de référence, fournissant ainsi un signal de correction qui est délivré à des moyens (100) pour commander les conditions de décapage.
caractérisé en ce que
chaque ensemble de buses oscillantes (21n) dans une première chambre de décapage (21a) d'un premier poste de décapage (21) est latéralement décalé par rapport aux ensembles de buses oscillantes (20n, 22n) dans des chambres de décapage adjacentes (20, 22) de postes de décapage adjacents (20a, 22a) du même côté de ladite bande (9a) et par rapport à l'ensemble de buses oscillantes (21n') dans ladite deuxième chambre facultative de décapage (21b) dudit premier poste de décapage (21) du côté opposé de ladite bande (9b), fournissant ainsi un double décalage. de sorte qu'aucune zone de ladite bande (9) ne reçoive un décapage par pulvérisation identique ou similaire à partir de postes de décapage adjacents (20, 21, 22),
les conditions de décapage étant commandées en ne modifiant que la forme d'onde de l'oscillation de la buse.

2. Appareil de décapage selon la revendication 1, caractérisé en ce que chacun desdits postes de décapage (20, 21, 22) comprend une seule chambre de décapage (20a, 21a, 22a), toutes les chambres de décapage étant situées du même côté de la bande.

3. Appareil de décapage selon la revendication 1 ou 2, caractérisé en ce que lesdites buses oscillantes (20n, 20n') oscillent
conformément à une forme d'onde donnée pour fournir un motif donné de pulvérisation de réactif de décapage sur la bande (9)
et conformément à une forme d'onde différente en réponse audit signal de correction afin de compenser, si nécessaire, les conditions de décapage variables ou les changements d'épaisseur de ladite bande (9) en fournissant un autre motif.

4. Appareil de décapage selon une ou plusieurs des revendications précédentes, caractérisé en ce que lesdites modifications de la forme d'onde sont réalisées en mouvement.

5. Appareil de décapage selon une ou plusieurs des revendications 1, 3 ou 4, caractérisé en ce que lesdits bancs (20h, 20h') des buses oscillantes (20n, 20n') desdites deux chambres de décapage (20a, 20b) d'un poste de décapage donné (20) oscillent conformément à ladite forme d'onde donnée.

6. Appareil de décapage selon la revendication 5, caractérisé en ce que lesdits moyens (100) destinés à commander les conditions de décapage comprennent un cylindre hydraulique actionnable par pression.

7. Appareil de décapage selon une ou plusieurs des revendications précédentes, caractérisé en ce que lesdites buses oscillantes (20n, 20n') de chacun desdits postes de décapage (20, 21, 22) oscillent conformément à une forme d'onde donnée,
et en ce que les formes d'ondes données régissant l'oscillation desdites buses oscillantes (20, 20n') dans les postes de décapage adjacents (20, 21, 22) sont différentes les unes des autres.

8. Appareil de décapage selon une ou plusieurs des revendications 1, 3 à 4 et 7, caractérisé en ce que ledit premier banc de buses oscillantes (20h) de ladite première chambre de décapage (20a) dans un poste de décapage donné (20) oscille conformément à une première forme d'onde donnée et en ce que ledit deuxième banc (20h') de buses oscillantes de ladite deuxième chambre de décapage (20b) dans ledit poste de décapage donné (20) oscille conformément à une deuxième forme d'onde donnée.

9. Appareil de décapage selon la revendication 8, caractérisé en ce que lesdits moyens (100) pour commander les conditions de décapage comprennent au moins deux cylindres hydrauliques actionnables par pression pour commander la forme d'onde d'au moins certaines des buses (21n) indépendamment d'autres buses (21n').

10. Appareil de décapage selon une ou plusieurs des revendications précédentes, caractérisé en ce que lesdits bancs (20h, 20h') des buses ont un axe d'oscillation décalé d'environ 33 degrés par rapport à la normale à la surface de ladite bande métallique (9).

11. Procédé de décapage par pulvérisation d'une bande métallique (9) par la distribution uniforme de réactif de décapage sur ladite bande (9), consistant à :
établir un ou plusieurs premiers motifs de grille de buses oscillantes (20n, 21n, 22n) pour décaper ladite bande (9) à partir d'un côté de ladite bande (9a) ;
éventuellement établir un ou plusieurs seconds motifs de grille de buses oscillantes (20n', 21n', 22n') pour décaper ladite bande (9) à partir du côté opposé de ladite bande (9b);
chacun desdits motifs de grille étant latéralement décalé par rapport à des motifs de grille adjacents du même côté de la bande (9a) et par rapport au motif de grille opposé facultatif du côté opposé de ladite bande (9b), fournissant ainsi un double décalage,
faire osciller toutes les buses (20n, 20n') conformément à une forme d'onde donnée tout en pulvérisant un réactif de décapage depuis les buses oscillantes (20n, 20n') sur la bande métallique (9),
mesurer la taille ou la forme des trous dans ladite bande (9) pour générer ainsi un signal comparé à un signal de référence, fournissant ainsi un signal de correction permettant de commander les conditions de décapage en ne modifiant que la forme d'onde de l'oscillation de la buse.

12. Procédé selon la revendication 11, caractérisé en ce que lesdits motifs de grille des buses oscillantes (20n) destinés à décaper la bande métallique sont prévus uniquement sur un côté de ladite bande (9a).

13. Procédé selon la revendication 11 ou 12, caractérisé en ce que les modifications de la forme d'onde sont réalisées en mouvement.

14. Procédé selon une ou plusieurs des revendications 11 à 13, caractérisé en ce qu'il comprend l'étape consistant à faire osciller chacune des buses (20n, 20n') sur un angle d'environ 60 degrés, l'axe du centre d'oscillation étant situé à un angle d'environ 33 degrés par rapport à un axe perpendiculaire à la surface de ladite bande (9).

15. Procédé selon une ou plusieurs des revendications 11 à 14, caractérisé en ce que les formes d'onde données régissant l'oscillation de motifs de grille adjacents sur le même côté de la bande métallique (9a) sont différentes les unes des autres.

16. Procédé selon une ou plusieurs des revendications 11 et 13 à 15, caractérisé en ce que les formes d'onde données régissant l'oscillation des motifs de grille opposés sur des côtés opposés de ladite bande (9a, 9b) sont différentes les unes des autres.
